# EUROPÄISCHE PATENTANMELDUNG

(11) **EP 3 462 822 A1**
(43) Veröffentlichungstag der Anmeldung: **03.04.2019**
(21) Anmeldenummer: 17194129.7
(22) Anmeldetag: 29.09.2017
(51) Int. Cl.: H05K 7/14

(54) **ELEKTRISCHER UMRICHTER**

(71) Anmelder: Siemens Aktiengesellschaft, 80333 München (DE)
(72) Erfinder: PFEFFERLEIN, Stefan, 90562 Heroldsberg (DE)

(57) **Zusammenfassung**

Die Erfindung betrifft einen elektrischen Umrichter (1) für den Betrieb von zusammensteckbaren Umrichterkomponenten, aufweisend eine erste elektronische Baugruppe (2) mit elektronischen Bauelementen (3), einen Baugruppenträger (4), ein Gehäuse-Chassis (5) und einen Gehäusedeckel (6), wobei zumindest eines der elektronischen Bauelemente (3) ein Leistungshalbleiterschalter (19) mit breitem Bandabstand aus GaN oder aus InGaN ist und der mindestens eine Leistungshalbleiterschalter (19) im Betrieb des elektrischen Umrichters (1) mit einer Sperrspannung von mindestens 400V und mit einer Taktfrequenz von mindestens 40kHz betrieben wird, wobei die erste elektronische Baugruppe (2) mittels Verbindungselementen (7) mit dem Baugruppenträger (4) gesteckt mechanisch verbunden ist und wobei die mit dem Baugruppenträger (4) zusammengesteckte erste elektronische Baugruppe (2) mittels weiterer Verbindungselemente (8) über Rastelemente (9) des Gehäuse-Chassis (5) mit dem Gehäuse-Chassis (5) oder über Rastelemente des Gehäusedeckels mit dem Gehäusedeckel gesteckt und gerastet mechanisch verbunden ist.

## Beschreibung

Die Erfindung betrifft einen elektrischen Umrichter für den Betrieb von zusammensteckbaren Umrichterkomponenten mit einer ersten elektronischen Baugruppe mit elektronischen Bauelementen, einem Baugruppenträger, einem Gehäuse-Chassis und einem Gehäusedeckel.

Elektrische bzw. elektronische Umrichterkomponenten von elektrischen Umrichtern, wie z.B. elektronische Baugruppen in Form von Leiterplatten mit elektronischen Bauelementen, Baugruppenträgern zur Aufnahme der elektronischen Baugruppen sowie Gehäuse-Chassis und Gehäusedeckel der elektrischen Umrichter werden beim Zusammenbau des elektrischen Umrichters im Allgemeinen durch kraftschlüssige Verbindungsmittel mechanisch miteinander verbunden.

Derartige kraftschlüssige Verbindungsmittel sind z.B. Schrauben für mechanisch lösbare Verbindungen oder auch Nieten für mechanisch unlösbare Verbindungen. Diese oftmals aus metallischen Materialien bestehenden kraftschlüssigen Verbindungsmittel kommen auch deshalb in heutigen elektrischen Umrichtern zum Einsatz, weil insbesondere die Baugruppenträger, das Gehäuse-Chassis und ggf. auch der Gehäusedeckel dieser elektrischen Umrichter entweder Teil von massiven metallischen Kühlkörpern zur Entwärmung der elektronischen Bauelemente, insbesondere zur Entwärmung von Leistungshalbleiterschaltern oder von Module mit Leistungshalbleiterschaltern sind oder sogar vollumfänglich als metallischer Kühlkörper ausgebildet sind.

Dies gilt insbesondere auch dann, wenn beispielsweise herkömmliche IGBT-Leistungshalbleiterschalter (aus Si oder SiC) im Betrieb mit hohen Sperrspannungen, beispielsweise größer 400V, mit hohen Taktfrequenzen, beispielsweise größer 40kHz, und mit Schaltströmen von beispielsweise größer 7A betrieben werden.

Diese Umrichterkomponenten, welche maßgeblich die gewichtsbestimmenden metallischen Materialien aufweisen, sind bzgl. derartiger kraftschlüssiger Verbindungsmittel im Allgemeinen für eine hohe Beanspruchung ihrer mechanischen Verbindungen ausgelegt.

Ferner wird auch aus Gründen der Kostenreduktion im Herstellungsprozess bzw. beim Materialeinsatz auch auf stoffschlüssige Verbindungstechnologien, wie z.B. dem Kleben, dem Löten oder anderen meist mechanisch nichtlösbaren Verbindungstechnologien, zurückgegriffen.

Dies kann den Aufbau und Zusammenbau von kompakten elektrischen Umrichtern mit Blick auf funktionale Integration von deren Umrichterkomponenten, von Materialeinsparungen und Reduktion von Schritten des Herstellungsprozesses unterstützen, da hier auf lösbare mechanische Verbindungen und den damit verbundenen Platz- und Materialbedarf möglichst verzichtet wird. Jedoch verhindert der Einsatz derartiger stoffschlüssiger Verbindungstechnologien insbesondere eine schnelle und zerstörungsfreie Demontage der Umrichterkomponenten bei Wartungs- und Reparatureinsätzen.

Ein weiterer Aspekt beim Betrachten von Verbindungstechnologien für elektrische Umrichter ist die Bestrebung der Hersteller, elektronische Baugruppen auf dem Baugruppenträger z.B. mit Schraubverbindungen vorzumontieren und diese vormontierte Kombination der genannten Umrichterkomponenten mit Gehäuseelementen des elektrischen Umrichters zu umhausen, um diese dann ebenfalls, z.B. mittels Schraubverbindungen, mechanisch zu befestigen.

Diese Aufbauweise führt allerdings oft zu Toleranzproblemen. Die Gehäuseelemente müssen dabei aus unterschiedlichen Fügerichtungen montiert werden und in engen Toleranzgrenzen aufeinander ausgerichtet sein, damit z.B. die erforderliche Schutzart bzgl. der IP-Schutzklassen (International Protection Codes) und der EMV (Elektromagnetische Verträglichkeit) erfüllt werden.

Auch erfordern Schraubverbindungen, z.B. für die mechanische Verbindung des Baugruppenträgers mit elektronischen Baugruppen am Umrichtergehäuse, einen ausreichenden Bauraum, was bzgl. eines kompakten, platzsparenden Aufbaus des elektrischen Umrichters eher hinderlich ist.

Eine weitere Aufbaualternative von elektrischen Umrichtern stellt z.B. der Turmaufbau von elektronischen Baugruppen dar, wobei diese auf ein Trägerchassis bzw. das Gehäuse-Chassis aufgesetzt und oftmals verschraubt sind. Dieses Konstrukt aus elektronischer Baugruppe und Trägerchassis bzw. Gehäuse-Chassis ist dann von einer Gehäusehülle bzw. dem Gehäusedeckel umfasst bzw. abgeschlossen und ebenfalls meist mittels Schraubverbindungen mechanisch verbunden.

Diese Art der Aufbautechnologie eignet sich oft nur dann, wenn das Chassis keine hohen Wandungen aufweist, da sonst die Gefahr besteht, dass die elektronischen Baugruppen mechanisch und elektrisch nicht toleranzsicher eingebaut sind, was wiederum die Funktion der elektronischen Baugruppen im Betrieb beeinträchtigen kann.

Diese Betrachtungen betreffen neben den elektrischen Umrichtern der Antriebs- und Energieversorgungstechnik prinzipiell auch Automatisierungsgeräte für weitere Automatisierungsaufgaben, wie z.B. Automatisierungsgeräte mit speicherprogrammierbaren Steuerungen (SPS) sowie Aktoren (Stellglieder, Ventile etc.) und Sensoren (Messumformer) für die Prozessautomation, welche nicht oder nicht ausschließlich für Antriebs-und Energieversorgungslösungen ausgewiesen sind.

Der Erfindung liegt daher die Aufgabe zugrunde, einen elektrischen Umrichter bereitzustellen, welcher für die mechanische Verbindung von Umrichterkomponenten, wie der elektronischen Baugruppe, dem Baugruppenträger, dem Gehäuse-Chassis und dem Gehäusedeckel bei gleichbleibender mechanischer Belastungsfähigkeit eine Verbindungstechnologie bereitstellt, die einen kompakteren, bauraumsparenden Aufbau des elektrischen Umrichters ermöglicht und den Einsatz von metallischen Materialien bezüglich dieser mechanischen Verbindungen weiter reduziert.

Die Aufgabe wird durch einen elektrischen Umrichter mit den in Anspruch 1 angegebenen Merkmalen gelöst.

Der Erfindung liegt die Erkenntnis zugrunde, dass mit Einführung von Leistungshalbleiterschaltern mit hoher Bandbreite aus GaN oder InGaN, welche insbesondere mit hohen Sperrspannungen (>400V) und hohen Taktfrequenzen (>40kHz) bei Schaltströmen größer 7A betrieben werden, auf bisher zum Einsatz kommende massive metallische Kühlkörper, welche bis heute oft vollständig oder zumindest teilweise in Gehäuse-Chassis und/oder in Gehäusedeckeln der elektrischen Umrichter integriert sind, verzichtet werden kann oder zumindest bezüglich ihres Platz- und Materialbedarfs wesentlich reduziert werden können. Dies wiederum eröffnet neue Optionen für die Verbindung und die Anordnung von Umrichterkomponenten bei elektrischen Umrichtern.

Für die Lösung der Aufgabe wird ein elektrischer Umrichter für den Betrieb von zusammensteckbaren Umrichterkomponenten vorgeschlagen, aufweisend eine erste elektronische Baugruppe mit elektronischen Bauelementen, einen Baugruppenträger, ein Gehäuse-Chassis und einen Gehäusedeckel, wobei zumindest eines der elektronischen Bauelemente ein Leistungshalbleiterschalter mit breitem Bandabstand aus GaN oder aus InGaN ist und der mindestens eine Leistungshalbleiterschalter im Betrieb des elektrischen Umrichters mit einer Sperrspannung von mindestens 400V und mit einer Taktfrequenz von mindestens 40kHz betrieben wird, wobei die erste elektronische Baugruppe mittels Verbindungselementen mit dem Baugruppenträger gesteckt mechanisch verbunden ist und wobei die mit dem Baugruppenträger zusammengesteckte erste elektronische Baugruppe mittels weiterer Verbindungselemente über Rastelemente des Gehäuse-Chassis mit dem Gehäuse-Chassis oder über Rastelemente des Gehäusedeckels mit dem Gehäusedeckel gesteckt und gerastet mechanisch verbunden ist.

Für den Einsatz des mindestens einen Leistungshalbleiterschalters mit breitem Bandabstand aus GaN oder aus InGaN als elektronisches Bauelement ist auch bei einem Betrieb mit höheren Sperrspannungen (>400V) und Taktfrequenzen (>40kHz) der Einsatz von massiven metallischen Kühlkörpern für die Entwärmung dieses Leistungshalbleiterschalter kaum noch notwendig. In der Regel sind diese massiven metallischen Kühlkörper raumfordernd und gewichtsbestimmend, werden meist als zentraler Verbindungspunkt des elektrischen Umrichters verwendet und schränken auch schon deshalb die Anordnungs- und Verbindungsmöglichkeiten für die anderen Umrichterkomponenten wesentlich ein.

Im erfindungsgemäßen elektrischen Umrichter können auch Leistungshalbleiterschalter mit breitem Bandabstand aus GaN oder aus InGaN in einer Brückenschaltungen verwendet werden, beispielsweise ausgebildet als Sechspuls-Brückenschaltungen (B6-Brücke) mit dann sechs Leistungshalbleiterschaltern, wobei auch dafür massive metallische Kühlkörper im Gegensatz zu vergleichbaren Lösungen beispielsweise mit SiC-Leistungshalbleiter nicht benötigt werden. Somit ist der mindestens eine Leistungshalbleiterschalter hier ebenfalls als Modul mit mehreren Leistungshalbleiterschaltern zu verstehen und z.B. als Brückenschaltung ausgebildet.

Mittels der Verbindungselemente und Rastelemente des erfindungsgemäßen elektrischen Umrichters können die zusammensteckbaren Umrichterkomponenten in vorteilhafter Weise aufwandsarm vormontiert, eng verschachtelt und somit kompakt und platzsparend aufgebaut und vergleichsweise auch aufwandsarm für Wartungszwecke auseinandergenommen werden.

Ferner geben die Verbindungselemente, gemeinsam mit dem Baugruppenträger und den Rastelementen des Gehäuse-Chassis oder des Gehäusedeckels, der ersten elektronischen Baugruppe in besonders vorteilhaft Weise die für deren Betrieb erforderliche Stabilität.

Vorteilhafte Ausgestaltungsformen des elektrischen Umrichters sind in den abhängigen Ansprüchen angegeben.

Bei einer ersten vorteilhaften Ausgestaltungsform des erfindungsgemäßen elektrischen Umrichters ist die erste elektronische Baugruppe unmittelbar mittels Verbindungselementen und/oder mittelbar über den Baugruppenträger mittels Verbindungselementen mit mindestens einer weiteren elektronischen Baugruppe, welche elektronische Bauelemente aufweist, gesteckt mechanisch verbunden.

Da die weitere elektronische Baugruppe sowohl unmittelbar über die Verbindungselemente wie auch mittelbar über die erste elektronische Baugruppe und die Verbindungselemente mit dem Baugruppenträger mechanisch verbunden sein kann, wird der Baugruppenträger in dieser Form nicht mehr als alleiniger und meist zentraler Verbindungspunkt für die Verbindung einer Mehrzahl der elektronischen Baugruppen untereinander wie auch mit dem Gehäuse-Chassis und/oder dem Gehäusedeckel benötigt. Gleichzeitig verbleibt aber seine Gruppierungsfunktionalität für die elektronischen Baugruppen, was auch stabilitätsfördern für den elektrischen Umrichter ist.

Demnach erhöht sich insbesondere die Flexibilität für die Anordnung der elektronischen Baugruppen im elektrischen Umrichter, was je nach den elektrischen Anforderungen an den elektrischen Umrichter einen kompakten und verschachtelten Aufbau mit engsten Zwischenräumen der elektronischen Baugruppen untereinander ermöglicht. Diese Zwischenräume werden im Wesentlichen durch die elektrischen Vorgaben an die Betriebssicherheit des elektrischen Umrichters bestimmt, wie zum Beispiel Schutz vor einem elektrischen Überschlag bzw. elektrischen Kriechstrecken zwischen im Betrieb stromführenden bzw. spannungsaufweisenden Leitern der elektronischen Bauelemente auf den elektronischen Baugruppen.

Bei einer weiteren vorteilhaften Ausgestaltungsform des erfindungsgemäßen elektrischen Umrichters ist die mindestens eine weitere elektronische Baugruppe mittels weiterer Verbindungselemente über Rastelemente des Gehäuse-Chassis mit dem Gehäuse-Chassis oder über Rastelemente des Gehäusedeckels mit dem Gehäusedeckel gesteckt und gerastet mechanisch verbunden.

Mittels der Verbindungelemente können elektronische Baugruppen als zusammensteckbare Umrichterkomponenten je nach Anforderung zusammengesteckt werden, was beispielhaft die erste elektronische Baugruppe, den Baugruppenträger und die weitere elektronische Baugruppe umfassen kann.

In vorteilhafter Weise bilden die zusammengesteckten elektronischen Baugruppen mittels der in die Rastelemente des Gehäuse-Chassis oder des Gehäusedeckels eingerasteten weiteren Verbindungselemente nach dem Einrasten eine stabile mechanische Verbindung mit dem Gehäuse-Chassis oder dem Gehäusedeckel.

Der Vorgang des Einrastens der zusammengesteckten elektronischen Baugruppen kann ohne weitere zusätzliche Hilfsmittel allein durch Krafteinwirkung auf die zusammengesteckten elektronischen Baugruppen erfolgen. Bei Bedarf ist diese stabile mechanische Verbindung der zusammengesteckten elektronischen Baugruppen wieder ausrastbar und somit die Zusammensetzung der mittels der Verbindungselemente zusammengesteckten elektronischen Baugruppen zerstörungsfrei auflösbar. Dies unterstützt den modularen Aufbau und die bedarfsgerechte Austauschbarkeit bzw. Anpassbarkeit der elektronischen Baugruppen des elektrischen Umrichters in vorteilhafter Weise.

Bei einer weiteren vorteilhaften Ausgestaltungsform des erfindungsgemäßen elektrischen Umrichters weisen die weiteren Verbindungselemente jeweils einen Verbindungskopf auf, welcher in eine Rastelement-Einbuchtung von jeweils einem der Rastelemente eingesteckt und verrastet ist.

Diese Verbindungsköpfe sind in vorteilhafter auf die jeweilige Rastelement-Einbuchtung bezüglich ihrer Abmaße und Formgebung abgestimmt, um einerseits eine jeweils stabile mechanische Verbindung zwischen weiterem Verbindungselement und zugehörigem Rastelement zu erzeugen und andererseits diese stabile mechanische Verbindung auch als zerstörungsfrei lösbar auszubilden.

Bei einer weiteren vorteilhaften Ausgestaltungsform des erfindungsgemäßen elektrischen Umrichters weisen die Verbindungsköpfe der weiteren Verbindungselemente und die mit ihnen jeweils verbundene Rastelement-Einbuchtung der Rastelemente eine zumindest teilweise ausgebildete Kugelform auf oder weisen die Verbindungsköpfe der weiteren Verbindungselemente und die mit ihnen jeweils verbundene Rastelement-Einbuchtung der Rastelemente eine rechteckige Form auf oder weisen die Verbindungsköpfe der weiteren Verbindungselemente und die mit ihnen jeweils verbundene Rastelement-Einbuchtung der Rastelemente eine zugespitzte Form auf oder weisen die Verbindungsköpfe der weiteren Verbindungselemente und die mit ihnen jeweils verbundene Rastelement-Einbuchtung der Rastelemente eine zylindrische Form auf.

Während die rechteckige Form der Verbindungsköpfe und der Rastelement-Einbuchtungen die Stabilität der mechanischen Verbindung der weiteren Verbindungselemente mit dem jeweiligen Rastelement im eingerasteten Zustand vorteilhaft unterstützt, wird das Lösen der mechanischen Verbindung durch Ausrasten der Verbindungsköpfe aus der jeweiligen Rastelement-Einbuchtungen insbesondere durch die zumindest teilweise ausgebildete Kugelform wie auch durch die zylindrische Form der Verbindungsköpfe und der Rastelement-Einbuchtungen in vorteilhafter Weise erleichtert. Die zugespitzte Form der Verbindungsköpfe und der Rastelement-Einbuchtungen bietet sich vorteilhaft dann an, wenn die Auflagefläche der Verbindungsköpfe in der Rastelement-Einbuchtung sehr klein gehalten werden soll, um beispielsweise mechanische Schwingungen vom Gehäuse-Chassis oder vom Gehäusedeckel möglichst in geringem Umfang auf die weiteren Verbindungselemente und somit auf die elektronischen Baugruppen zu übertragen.

Bei einer weiteren vorteilhaften Ausgestaltungsform des erfindungsgemäßen elektrischen Umrichters weist das Gehäuse-Chassis oder der Gehäusedeckel mindestens eine Führungsschiene auf, mittels derer mindestens einer der Verbindungsköpfe zu der jeweiligen Rastelement-Einbuchtungen führbar ist.

Die mindestens eine Führungsschiene im Gehäuse-Chassis oder im Gehäusedeckel bietet den Vorteil, dass bei einer Einführung der Verbindungsköpfe der weiteren Verbindungselemente in die jeweiligen Rastelement-Einbuchtungen der Rastelemente wie auch bei einer Ausführung aus diesen, ein Verkanten und somit eine Beschädigung der über ihre Verbindungselemente zusammengesetzten elektronischen Baugruppen weitestgehend vermieden wird.

Bei einer weiteren vorteilhaften Ausgestaltungsform des erfindungsgemäßen elektrischen Umrichters sind die Rastelemente für sich allein oder gemeinsam mit dem Gehäuse-Chassis oder dem Gehäusedeckel mechanisch beweglich ausgebildet und weisen die Rastelemente ein Mittel zum Ausrasten des jeweiligen weiteren Verbindungselementes auf.

Soweit die Rastelemente für sich allein beweglich ausgebildet sind, besteht der Vorteil, dass die Aktivitäten des Einrastens und des Ausrastens kaum eine mechanische Belastung für das Gehäuse-Chassis oder des Gehäusedeckels hervorrufen.

Ist das Rastelement eher starr im Sinne der gemeinsamen Beweglichkeit mit dem Gehäuse-Chassis oder dem Gehäusedeckel ausgebildet, entscheidet das Materialgefüge von Rastelement und Gehäuse-Chassis oder Rastelement und Gehäusedeckel welche Überdehnung des Materials für das Einrasten oder Ausrasten möglich ist. Der Vorteil liegt dann in der kostengünstigen Ausführung des Rastelementes bzgl. Konstruktion und Herstellung dieser Lösung.

Bei einer weiteren vorteilhaften Ausgestaltungsform des erfindungsgemäßen elektrischen Umrichters weist das Gehäuse-Chassis und/oder der Gehäusedeckel eine Öffnung zum Betätigen des Mittels zum Ausrasten des jeweiligen weiteren Verbindungselementes auf.

Bei einer weiteren vorteilhaften Ausgestaltungsform des erfindungsgemäßen elektrischen Umrichters ist der Gehäusedeckel mit dem Gehäuse-Chassis gesteckt und gerastet mechanisch verbunden.

Diese Ausgestaltungsform setzt die schon für die mechanische Verbindung der elektronischen Baugruppen mit dem Gehäuse-Chassis oder dem Gehäusedeckel bewährte Verbindungstechnologie der Steck-Rastverbindungen in vorteilhafter Weise fort. Sie kann z.B. derart weitergebildet werden, dass das Innenraumvolumen des elektrischen Umrichters, gekapselt durch Gehäuse-Chassis und Gehäusedeckel, unter Berücksichtigung der Anzahl der im Innenraum des elektrischen Umrichters zusammengesteckten elektronischen Baugruppen mittels mehrerer Raststufen änderbar ist.

Bei einer weiteren vorteilhaften Ausgestaltungsform des erfindungsgemäßen elektrischen Umrichters ist die mechanische Verbindung des Gehäusedeckels mit dem Gehäuse-Chassis eine schraubenlose mechanische Verbindung.

Schrauben haben den Nachteil, dass einerseits der benötigte Bauraum im elektrischen Umrichter vorgehalten werden muss. Andererseits ist durch die meist metallische Ausbildung der Schrauben der Gewichts- und Kostenfaktor für die Hersteller durchaus relevant. Ein Verzicht auf Schrauben ist, neben einem im Allgemeinen zwingenden Einsatz von Werkzeugen für deren Lösen bzw. Anziehen, schon von daher ein Vorteil für die mechanische Verbindung des Gehäusedeckels mit dem Gehäuse-Chassis.

Bei einer weiteren vorteilhaften Ausgestaltungsform des erfindungsgemäßen elektrischen Umrichters sind die Verbindungselemente und die weiteren Verbindungselemente mindestens zu 95% aus einem nichtmetallischen Material oder vollständig aus einem nichtmetallischem Material ausgebildet und ist das nichtmetallische Material insbesondere aus Kunststoff.

Aus Gewichtsgründen und Kostengründen ist der Verzicht auf metallische Werkstoffe für die Ausbildung der Verbindungselemente und der weiteren Verbindungselemente ein Vorteil für den elektrischen Umrichter. Ein Aufdampfen von Metallen auf Nichtmetalle, z.B. aus Schirmungsgründen oder aus Gründen der Leitung von Signalen über die Verbindungselemente und/oder die weiteren Verbindungselemente, ist jedoch ebenfalls möglich. Dabei kann der Einsatz des metallischen Materials bis zu 5% des entsprechenden Gesamtmaterialeinsatzes betragen.

Bei einer weiteren vorteilhaften Ausgestaltungsform des erfindungsgemäßen elektrischen Umrichters ist der Baugruppenträger mindestens zu 95% aus einem nichtmetallischen Material oder vollständig aus einem nichtmetallischem Material ausgebildet und ist das nichtmetallische Material insbesondere aus Kunststoff.

Aus Gewichtsgründen und Kostengründen ist der Verzicht auf metallische Werkstoffe für die Ausbildung des Baugruppenträgers ein Vorteil für den elektrischen Umrichter. Ein Aufdampfen von Metallen auf Nichtmetalle, z.B. aus Schirmungsgründen oder aus Gründen der Leitung von Signalen über den Baugruppenträger, ist jedoch ebenfalls möglich. Dabei kann der Einsatz des metallischen Materials bis zu 5% des entsprechenden Gesamtmaterialeinsatzes betragen.

Bei einer weiteren vorteilhaften Ausgestaltungsform des erfindungsgemäßen elektrischen Umrichters sind das Gehäuse-Chassis und/oder der Gehäusedeckel mindestens zu 95% aus einem nichtmetallischen Material oder vollständig aus einem nichtmetallischem Material ausgebildet und ist das nichtmetallische Material insbesondere aus Kunststoff.

Aus Gewichtsgründen und Kostengründen ist der Verzicht auf metallische Werkstoffe für die Ausbildung des Gehäuse-Chassis und/oder des Gehäusedeckels ein Vorteil für den elektrischen Umrichter. Ein Aufdampfen von Metallen auf Nichtmetalle, z.B. aus Schirmungsgründen oder aus Gründen der Leitung von Signalen über das Gehäuse-Chassis und/oder den Gehäusedeckel, ist jedoch ebenfalls möglich. Dabei kann der Einsatz des metallischen Materials bis zu 5% des entsprechenden Gesamtmaterialeinsatzes betragen.

Bei einer weiteren vorteilhaften Ausgestaltungsform des erfindungsgemäßen elektrischen Umrichters sind die mechanischen Verbindungen, welche mittels der Verbindungselemente und/oder der weiteren Verbindungselemente ausgebildet sind, schraubenlose mechanische Verbindungen.

Schrauben haben den Nachteil, dass einerseits der benötigte Bauraum im elektrischen Umrichter vorgehalten werden muss. Andererseits ist durch die meist metallische Ausbildung der Schrauben der Gewichts- und Kostenfaktor für die Hersteller durchaus relevant. Ein Verzicht auf Schrauben ist, neben einem im Allgemeinen zwingenden Einsatz von Werkzeugen für deren Lösen bzw. Anziehen, schon von daher ein Vorteil für die mechanische Verbindung, welche mittels der Verbindungselemente und/oder der weiteren Verbindungselemente herstellbar sind.

Bei einer weiteren vorteilhaften Ausgestaltungsform des erfindungsgemäßen elektrischen Umrichters wird der mindestens eine Leistungshalbleiterschalter im Betrieb des elektrischen Umrichters mit einem Schaltstrom von mindestens 7A betrieben.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Figuren näher erläutert werden. Es zeigt:
- FIG 1: eine schematische Explosionsdarstellung des erfindungsgemäßen elektrischen Umrichters,
- FIG 2: eine erste schematische Detaildarstellung als Ausführungsbeispiel des erfindungsgemäßen elektrischen Umrichters nach FIG 1,
- FIG 3: eine weitere schematische Detaildarstellung als Ausführungsbeispiel des erfindungsgemäßen elektrischen Umrichters nach FIG 1,
- FIG 4: eine erste schematische Darstellung eines Ausführungsbeispiels eines Rastelementes nach FIG 2 oder FIG 3,
- FIG 5: eine zweite schematische Darstellung eines Ausführungsbeispiels eines Rastelementes nach FIG 2 oder FIG 3 und
- FIG 6: eine dritte schematische Darstellung eines Ausführungsbeispiels eines Rastelementes nach FIG 2 oder FIG 3.

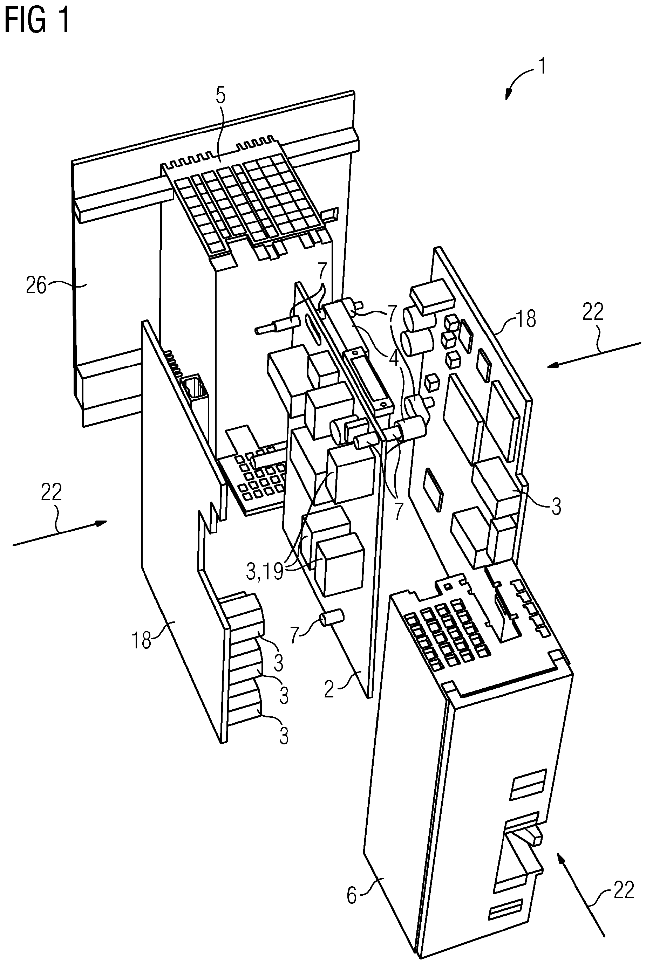

Die FIG 1 zeigt eine schematische Explosionsdarstellung des erfindungsgemäßen elektrischen Umrichters 1.

Auf einer ersten elektronischen Baugruppe 2 sind beispielhaft drei Leistungshalbleiterschalter 19 mit breitem Bandabstand aus GaN oder aus InGaN als elektronische Bauelemente 3 neben nicht weiter bezeichneten elektronischen Bauelementen angeordnet. Diese Leistungshalbleiterschaler 19 können auch Leistungshalbleiterschalter-Module mit derartigen Leistungshalbleiterschaltern kennzeichnen, welche z.B. als Sechspuls-Brückenschaltungen (B6-Brücken) ausgebildet sind. Diese erste elektronische Baugruppe 2 kann ferner einen Gleichrichter mit den Leistungshalbleiterschaltern 19 als Einspeisebaugruppe und/oder einen Wechselrichter mit den Leistungshalbleiterschaltern 19 als Lastbaugruppe eines Frequenzumrichters mit Gleichspannungszwischenkreis aufweisen.

Die erste elektronische Baugruppe 2 weist Verbindungselemente 7 auf, mittels derer die erste elektronische Baugruppe 2 mit dem Baugruppenträger 4 gesteckt mechanisch verbunden ist. An dem Baugruppenträger 4 sind an der der ersten elektronischen Baugruppe 2 des Baugruppenträgers 4 abgewandten Seite Verbindungselemente 7 angeordnet, mittels derer eine weitere elektronische Baugruppe 18 mit dem Baugruppenträger 4 verbindbar ist. Diese weitere elektronische Baugruppe 18 kann beispielsweise als Steuerbaugruppe ausgebildet sein, welche als elektronisches Bauelement 3, neben weiteren nicht bezeichneten elektronischen Bauelementen, eine Steuereinheit aufweist.

Die Seite der ersten elektronischen Baugruppe 2, auf welcher die Leistungshalbleiterschalter 19 mit breitem Bandabstand aus GaN oder aus InGaN als elektronische Bauelemente 3 angeordnet sind, weist Verbindungselemente 7 auf, mittels derer eine weitere elektrische Baugruppe 18 mit der ersten elektronischen Baugruppe 2 verbindbar ist. Diese weitere elektronische Baugruppe 18 kann beispielsweise als Eingangs- oder Ausgangsbaugruppe ausgebildet sein, welche als elektronische Bauelemente 3, neben weiteren nicht bezeichneten elektronischen Bauelementen, Eingangs- oder Ausgangsfilter aufweist.

Ferner zeigt FIG 1 ein Gehäuse-Chassis 5 des elektrischen Umrichters 1, welches an einer Rückwandplatte 26 aufgesteckt ist, sowie einen Gehäusedeckel 6 des elektrischen Umrichters 1. Diese Rückwandplatte 26 kann beispielsweise Teil des elektrischen Umrichters 1 sein oder Teil einer Rückwand eines Schaltschrankes.

Die erste elektronische Baugruppe 2 kann gemeinsam mit den jeweils an einer Seite der elektronischen Baugruppe 2 angeordneten beiden weiteren elektronischen Baugruppen 18 zusammengesteckt werden, wobei die auf die elektronischen Baugruppen 2,18 zeigenden Richtungspfeile 22 die Richtungen des Zusammensteckens dieser elektronischen Baugruppen 2, 18 bestimmen.

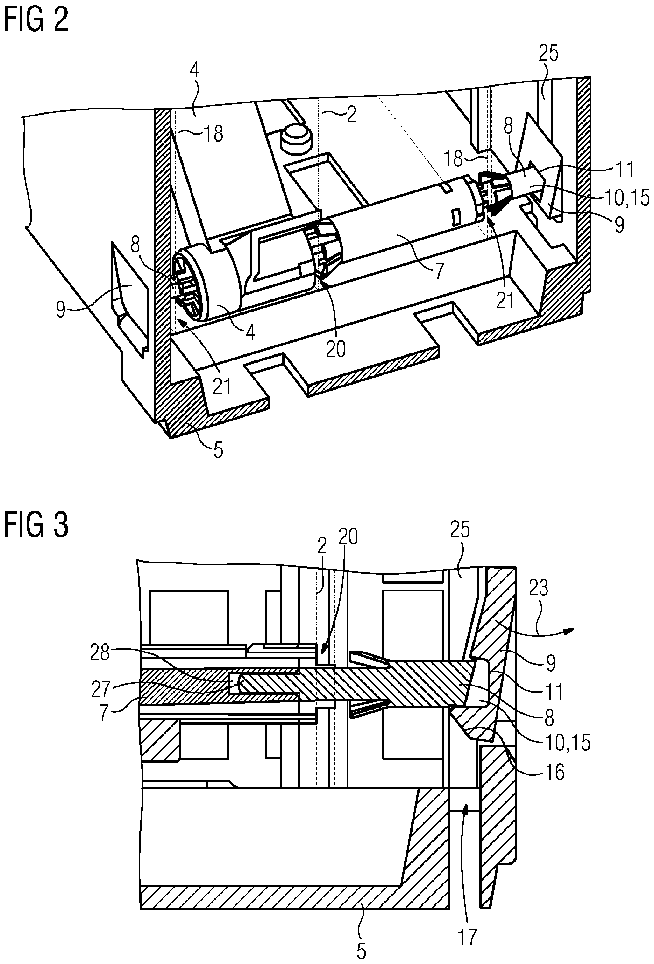

Diese dann zusammengesteckten elektronischen Baugruppen 2, 18 können einerseits in das Gehäuse-Chassis 5 eingesteckt und verrastet werden oder andererseits in den Gehäusedeckel 6 eingesteckt und verrastet werden. Die Darstellung des Steckens und des Rastens der zusammengesteckten elektronischen Baugruppen 2, 18 in das Gehäuse-Chassis 5 oder in den Gehäusedeckel 6 wird in FIG 1 nicht gezeigt, wobei die FIG 2 und die FIG 3 dazu eine detaillierte Darstellung für das Beispiel des Gehäuse-Chassis 5 aufweisen.

Werden die zusammengesteckten elektronischen Baugruppen 2, 18 in Richtung des Richtungspfeils 22, welcher auf den Gehäusedeckel 6 zeigt, in das Gehäuse-Chassis 5 eingesteckt und dort verrastet, kann der Gehäusedeckel 6 über das Gehäuse-Chassis 5 gesteckt und dort verrastet werden (in FIG 1 nicht gezeigt) .

Werden die zusammengesteckten elektronischen Baugruppen 2, 18 in Richtung des Richtungspfeils 22, welcher auf den Gehäusedeckel 6 zeigt, in den Gehäusedeckel 6 eingesteckt und dort verrastet, kann der Gehäusedeckel 6 in das Gehäuse-Chassis 5 eingesteckt und dort verrastet werden (in FIG 1 nicht gezeigt) .

FIG 2 zeigt eine erste schematische Detaildarstellung als Ausführungsbeispiel des erfindungsgemäßen elektrischen Umrichters 1 nach FIG 1.

Die erste elektronische Baugruppe 2 ist am Einbauort 20 mittels des Verbindungselementes 7 mit dem Baugruppenträger 4 gesteckt mechanisch verbunden. Eine der weiteren elektronischen Baugruppen 18 ist an einem Einbauort 21, angeordnet an der Seite der ersten elektronischen Baugruppe 2, welche dem Baugruppenträger 4 abgewandt ist, unmittelbar mittels dieses Verbindungselements 7 mit der ersten elektronischen Baugruppe 2 gesteckt mechanisch verbunden.

Die erste elektronische Baugruppe 2 am Einbauort 20 ist über den Baugruppenträger 4 mittels eines der Verbindungselemente (in FIG 2 nicht gezeigt) auf der dem Baugruppenträger 4 zugewanden Seite der ersten elektronischen Baugruppe 2 mit dem Baugruppenträger 4 gesteckt mechanisch verbunden.

Beide weiteren elektronischen Baugruppen 18 sind an deren jeweiligen Einbauorten 21 mittels zweier weiterer Verbindungselemente 8 mit jeweils einem der Rastelemente 9 des Gehäuse-Chassis 5 gesteckt und gerastet mechanisch verbunden.

Die zwei weiteren Verbindungselemente 8 weisen dazu jeweils einen Verbindungskopf 10 auf (nur einer der beiden Verbindungsköpfe 10 ist in FIG 2 dargestellt), welche jeweils in einer zylindrischen Form 15 ausgebildet sind und über jeweils eine Rastelement-Einbuchtung 11 der Rastelemente 9 (nur eine der beiden Rastelement-Einbuchtungen 11 ist in FIG 2 dargestellt) mit den Rastelementen (9) des Gehäuse-Chassis (5) gesteckt und gerastet mechanisch verbunden sind.

Mittels zweier Führungsschienen 25 (nur eine der beiden Führungsschienen 25 ist in FIG 2 dargestellt) sind die Verbindungsköpfe 10 (nur einer der beiden Verbindungsköpfe 10 ist in FIG 2 dargestellt) der zwei weiteren Verbindungselemente 8 in die jeweilige Rastelement-Einbuchtung 11 der Rastelemente 9 (nur eine der beiden Rastelement-Einbuchtungen 11 ist in FIG 2 dargestellt) führbar.

Mit FIG 3 wird eine weitere schematische Detaildarstellung als Ausführungsbeispiel des erfindungsgemäßen elektrischen Umrichters 1 nach FIG 1 gezeigt.

Die erste elektronische Baugruppe 2 am Einbauort 20, welche mittels des Verbindungselementes 7 mit dem Baugruppenträger gesteckt mechanisch verbindbar ist (der Baugruppenträger ist in FIG 3 nicht dargestellt), ist mittels des Verbindungskopfes 10 des weiteren Verbindungselementes 8 über die Rastelement-Einbuchtung 11 des Rastelementes 9 des Gehäuse-Chassis 5 mit dem Gehäuse-Chassis 5 gesteckt und gerastet mechanisch verbunden. Der Verbindungskopf 10 ist als zylindrische Form 15 ausgebildet.

Mittels der Führungsschiene 25 ist der Verbindungskopf 10 des weiteren Verbindungselementes 8 in die Rastelement-Einbuchtung 11 des Rastelementes 9 führbar.

Ferner zeigt FIG 3 eine mechanische Verbindung des Verbindungselementes 7 mit dem weiteren Verbindungselement 8, wobei die elektronischen Baugruppe 2 mittels der beiden Verbindungselemente 7,8 mechanisch gesteckt verbunden ist.

Dazu weist das Verbindungselement 7 ein Sackloch 27 auf, in welche ein Dorn 28 des weiteren Verbindungselements 8 gesteckt ist.

Am Rastelement 9 ist ein Mittel 16 zum Ausrasten ausgebildet, dass durch eine Krafteinwirkung von einem Werkzeug, eingeführt in die Öffnung 17 des Chassis-Gehäuse 5, das Rastelement 9 in eine Ausraste-Bewegungsrichtung 23 bewegt, wobei der Verbindungskopf 10 des weiteren Verbindungselementes 8 aus der Rastelement-Einbuchtung 11 des Rastelementes 9 ausrasten und in die Führungsschiene 25 gleiten kann.

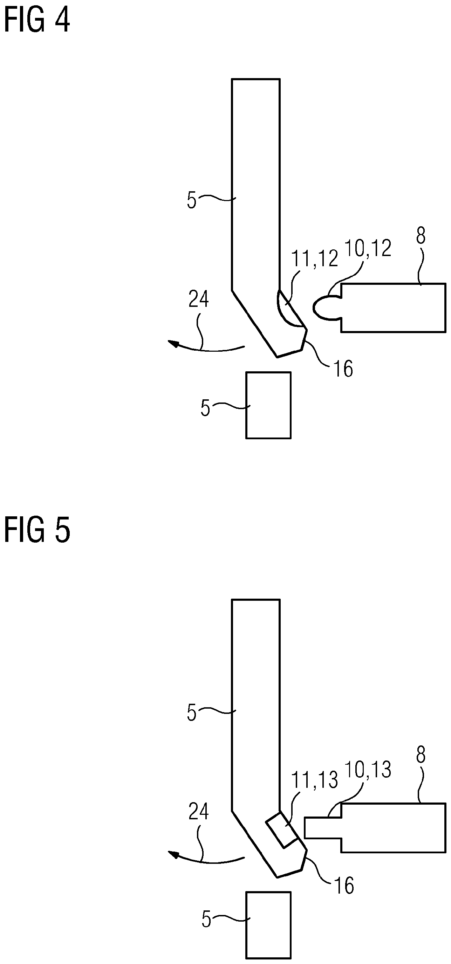

Die FIG 4 zeigt eine erste schematische Darstellung eines Ausführungsbeispiels einer Rastelement-Einbuchtung 11 nach FIG 2 oder FIG 3.

Das Gehäuse-Chassis 5 weist die Rastelement-Einbuchtung 11 des Rastelementes auf, wobei die Rastelement-Einbuchtung 11 ebenso wie der Verbindungskopf 10 des weiteren Verbindungselementes 8 als Kugelform 12 ausgebildet ist. Mit einer Krafteinwirkung in eine Einraste-Bewegungsrichtung 24 kann der Verbindungskopf 10 in die Rastelement-Einbuchtung 11 einrasten.

Durch die Krafteinwirkung auf das Mittel 16 zum Ausrasten kann der in die Rastelement-Einbuchtung 11 des Rastelementes eingerastete Verbindungskopf 10 des weiteren Verbindungselementes 8 ausgerastet werden.

Die FIG 5 zeigt eine zweite schematische Darstellung eines Ausführungsbeispiels einer Rastelement-Einbuchtung 11 nach FIG 2 oder FIG 3.

Das Gehäuse-Chassis 5 weist die Rastelement-Einbuchtung 11 des Rastelementes auf, wobei die Rastelement-Einbuchtung 11 ebenso wie der Verbindungskopf 10 des weiteren Verbindungselementes 8 als rechteckige Form 13 ausgebildet ist. Mit einer Krafteinwirkung in eine Einraste-Bewegungsrichtung 24 kann der Verbindungskopf 10 in die Rastelement-Einbuchtung 11 einrasten.

Durch die Krafteinwirkung auf das Mittel 16 zum Ausrasten kann der in die Rastelement-Einbuchtung 11 des Rastelementes eingerastete Verbindungskopf 10 des weiteren Verbindungselementes 8 ausgerastet werden.

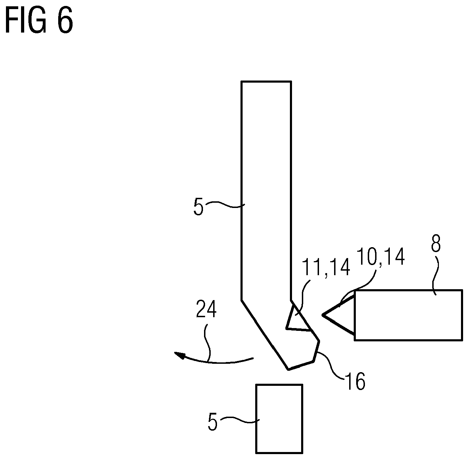

Die FIG 6 zeigt eine zweite schematische Darstellung eines Ausführungsbeispiels einer Rastelement-Einbuchtung 11 nach FIG 2 oder FIG 3.

Das Gehäuse-Chassis 5 weist die Rastelement-Einbuchtung 11 des Rastelementes auf, wobei die Rastelement-Einbuchtung 11 ebenso wie der Verbindungskopf 10 des weiteren Verbindungselementes 8 als zugespitze Form 14 ausgebildet ist. Mit einer Krafteinwirkung in eine Einraste-Bewegungsrichtung 24 kann der Verbindungskopf 10 in die Rastelement-Einbuchtung 11 einrasten.

Durch die Krafteinwirkung auf das Mittel 16 zum Ausrasten kann der in die Rastelement-Einbuchtung 11 des Rastelementes eingerastete Verbindungskopf 10 des weiteren Verbindungselementes 8 ausgerastet werden.

## Patentansprüche

1. Elektrischer Umrichter (1) für den Betrieb von zusammensteckbaren Umrichterkomponenten, aufweisend
- eine erste elektronische Baugruppe (2) mit elektronischen Bauelementen (3),
- einen Baugruppenträger (4),
- ein Gehäuse-Chassis (5) und
- einen Gehäusedeckel (6),
wobei
- zumindest eines der elektronischen Bauelemente (3) ein Leistungshalbleiterschalter (19) mit breitem Bandabstand aus GaN oder aus InGaN ist und der mindestens eine Leistungshalbleiterschalter (19) im Betrieb des elektrischen Umrichters (1) mit einer Sperrspannung von mindestens 400V und mit einer Taktfrequenz von mindestens 40kHz betrieben wird,
- die erste elektronische Baugruppe (2) mittels Verbindungselementen (7) mit dem Baugruppenträger (4) gesteckt mechanisch verbunden ist und
- die mit dem Baugruppenträger (4) zusammengesteckte erste elektronische Baugruppe (2) mittels weiterer Verbindungselemente (8) über Rastelemente (9) des Gehäuse-Chassis (5) mit dem Gehäuse-Chassis (5) oder über Rastelemente des Gehäusedeckels mit dem Gehäusedeckel gesteckt und gerastet mechanisch verbunden ist.

2. Elektrischer Umrichter (1) nach Anspruch 1, wobei die erste elektronische Baugruppe (2) unmittelbar mittels Verbindungselementen (7) und/oder mittelbar über den Baugruppenträger (4) mittels Verbindungselementen (7) mit mindestens einer weiteren elektronischen Baugruppe (18), welche elektronische Bauelemente (3) aufweist, gesteckt mechanisch verbunden ist.

3. Elektrischer Umrichter (1) nach Anspruch 2, wobei die mindestens eine weitere elektronische Baugruppe (18) mittels weiterer Verbindungselemente (8) über Rastelemente (9) des Gehäuse-Chassis (5) mit dem Gehäuse-Chassis (5) oder über Rastelemente des Gehäusedeckels (6) mit dem Gehäusedeckel (6) gesteckt und gerastet mechanisch verbunden ist.

4. Elektrischer Umrichter (1) nach einem der vorhergehenden Ansprüche, wobei die weiteren Verbindungselemente (8) jeweils einen Verbindungskopf (10) aufweisen, welcher in eine Rastelement-Einbuchtung (11) von jeweils einem der Rastelemente (9) eingesteckt und verrastet ist.

5. Elektrischer Umrichter (1) nach Anspruch 4, wobei
- die Verbindungsköpfe (10) der weiteren Verbindungselemente (8) und die mit ihnen jeweils verbundene Rastelement-Einbuchtung (11) der Rastelemente (9) eine zumindest teilweise ausgebildete Kugelform (12) aufweisen oder
- die Verbindungsköpfe (10) der weiteren Verbindungselemente (8) und die mit ihnen jeweils verbundene Rastelement-Einbuchtung (11) der Rastelemente (9) eine rechteckige Form (13) aufweisen oder
- die Verbindungsköpfe (10) der weiteren Verbindungselemente (8) und die mit ihnen jeweils verbundene Rastelement-Einbuchtung (11) der Rastelemente (9) eine zugespitzte Form (14) aufweisen oder
- die Verbindungsköpfe (10) der weiteren Verbindungselemente (8) und die mit ihnen jeweils verbundene Rastelement-Einbuchtung (11) der Rastelemente (9) eine zylindrische Form (15) aufweisen.

6. Elektrischer Umrichter (1) nach einem der vorhergehenden Ansprüche, wobei das Gehäuse-Chassis (5) oder der Gehäusedeckel (6) mindestens eine Führungsschiene (25) aufweist, mittels derer mindestens einer der Verbindungsköpfe (10) zu der jeweiligen Rastelement-Einbuchtungen (11) führbar ist.

7. Elektrischer Umrichter (1) nach einem der vorhergehenden Ansprüche, wobei die Rastelemente (9) für sich allein oder gemeinsam mit dem Gehäuse-Chassis (5) oder dem Gehäusedeckel mechanisch beweglich ausgebildet sind und die Rastelemente (9) ein Mittel (16) zum Ausrasten des jeweiligen weiteren Verbindungselementes (8) aufweisen.

8. Elektrischer Umrichter (1) nach Anspruch 7, wobei das Gehäuse-Chassis (5) und/oder der Gehäusedeckel eine Öffnung (17) zum Betätigen des Mittels (16) zum Ausrasten des jeweiligen weiteren Verbindungselementes (8) aufweist.

9. Elektrischer Umrichter (1) nach einem der vorhergehenden Ansprüche, wobei der Gehäusedeckel (6) mit dem Gehäuse-Chassis (5) gesteckt und gerastet mechanisch verbunden ist.

10. Elektrischer Umrichter (1) nach Anspruch 9, wobei die mechanische Verbindung des Gehäusedeckels (6) mit dem Gehäuse-Chassis (5) eine schraubenlose mechanische Verbindung ist.

11. Elektrischer Umrichter (1) nach einem der vorhergehenden Ansprüche, wobei die mechanischen Verbindungselemente (7) und die weiteren mechanischen Verbindungselemente (8) mindestens zu 95% aus einem nichtmetallischen Material oder vollständig aus einem nichtmetallischem Material ausgebildet sind und wobei das nichtmetallische Material insbesondere aus Kunststoff ist.

12. Elektrischer Umrichter (1) nach einem der vorhergehenden Ansprüche, wobei der Baugruppenträger (4) mindestens zu 95% aus einem nichtmetallischen Material oder vollständig aus einem nichtmetallischem Material ausgebildet ist und wobei das nichtmetallische Material insbesondere aus Kunststoff ist.

13. Elektrischer Umrichter (1) nach einem der vorhergehenden Ansprüche, wobei das Gehäuse-Chassis (5) und/oder der Gehäusedeckel (6) mindestens zu 95% aus einem nichtmetallischen Material oder vollständig aus einem nichtmetallischem Material ausgebildet sind und wobei das nichtmetallische Material insbesondere aus Kunststoff ist.

14. Elektrischer Umrichter (1) nach einem der vorhergehenden Ansprüche, wobei die mechanischen Verbindungen, welche mittels der Verbindungselemente (7) und/oder der weiteren Verbindungselemente (8) ausgebildet sind, schraubenlose mechanische Verbindungen sind.

15. Elektrischer Umrichter (1) nach einem der vorhergehenden Ansprüche, wobei der mindestens eine Leistungshalbleiterschalter (19) im Betrieb des elektrischen Umrichters (1) mit einem Schaltstrom von mindestens 7A betrieben wird.
